# EUROPEAN PATENT SPECIFICATION

(11) **EP 1 903 119 B1**
(45) Date of publication and mention of the grant of the patent: **23.09.2015**
(21) Application number: 06745599.8
(22) Date of filing: 24.04.2006
(51) Int. Cl.: C22C 9/00, C25C 1/12, C25C 7/06, H01L 21/60, C22B 15/14

(54) **A METHOD OF MANUFACTURING HIGH PURITY COPPER**
VERFAHREN ZUR HERSTELLUNG VON ULTRAHOCHREINES KUPFER
PROCÉDÉ DE FABRICATION DU CUIVRE DE PURETÉ EXTRÊMEMENT ÉLEVÉE

(30) Priority: 15.06.2005 JP 2005174896
(43) Date of publication of application: 26.03.2008
(60) Divisional application: 14188802.4
(73) Proprietor: JX Nippon Mining & Metals Corporation, Tokyo 100-8164 (JP)
(72) Inventor: SHINDO, Yuichiro Nippon Mining & Metals Co. Ltd., Kitaibabaraki-shi, Ibaraki 3191535 (JP); TAKEMOTO, Kouichi Nippon Mining & Metals Co. Ltd., Kitaibaraki-shi, Ibaraki 3191535 (JP)
(74) Representative: Hoarton, Lloyd Douglas Charles
(86) International application number: PCT/JP2006/308521
(87) International publication number: WO 2006/134724

(56) References cited:
- WO-A1-2005/073434
- WO-A1-2005/073434
- JP-A- 04 214 090
- JP-A- 04 259 359
- JP-A- 08 108 251
- JP-A- 09 063 362
- JP-A- 10 007 491
- JP-A- H02 185 990

## Description

### TECHNICAL FIELD

The present invention relates to a method of manufacturing ultrahigh purity copper.

### BACKGROUND ART

Conventionally, a gold wire has been used as the bonding wire for electrically connecting a silicon chip as the semiconductor element and the lead frame. Nevertheless, from the perspective that a gold wire is expensive and the strength thereof is inferior to copper, proposals have been made for switching to a copper wire (Non-Patent Documents 1 and 2).

High purity copper is characterized in that it is soft since the recrystallization temperature is low, it has favorable workability since there is hardly any brittleness in the intermediate temperature range, and it has high thermal conductivity since the electrical resistance is small at ultracold temperatures. It is also characterized by characteristic improvement due to addition of infinitesimal quantity of elements and great impact of impurity contamination on the characteristics.

JP H02 185990 discloses a method of manufacturing copper having a purity of 7N or greater

The foregoing conventional technologies utilize such characteristics of high purity copper to manufacture a bonding wire for semiconductor elements.

Nevertheless, a copper wire also entails several drawbacks; for instance, a copper wire is easily oxidized when forming the tip thereof into a ball shape, and there is a problem in that the silicon chip will be damaged when the ball shape is inferior or because the ball is too hard.

Proposals have been made to overcome the foregoing problems that arise during the shaping of the ball and with regard to the hardness of copper; namely, employing a protective atmosphere (reduction or inert atmosphere), and realizing copper having a purity level of 4N to 6N by eliminating impurities so as to soften such copper.

As conventional technologies of copper bonding wires, numerous documents have been disclosed; for instance, a copper bonding wire wherein the impurities are 10ppm or less (refer to Patent Document 1), a copper bonding wire wherein the impurities containing B are 50ppm or less (refer to Patent Document 2), a bonding wire for use in a semiconductor element wherein the copper purity is 99.999% or higher and the S content is 0.0005% or less (refer to Patent Document 3), a copper bonding wire comprised of high purity copper subject to annealing during the wire drawing process (refer to Patent Document 4), a bonding wire for use in a semiconductor device wherein the total content of impurities is 5ppm or less, and the rupture strength is 18 to 28kg/mm² (refer to Patent Document 5), a copper bonding wire with adjusted crystal grains wherein the impurities are 10ppm or less (refer to Patent Document 6), a bonding wire for use in a semiconductor element wherein the copper purity is 99.999% or higher, the S content is 0.0005% or less, and 0.02% of In, Hf and Mg is added thereto (refer to Patent Document 7), a bonding wire for use in a semiconductor element wherein the copper purity is 99.999% or higher, the S content is 0.0005% or less, and the alkali metals elements and alkali earth metal elements are 0.0001% or less (refer to Patent Document 8), a bonding wire for use in a semiconductor element wherein the copper purity is 99.999% or higher, the S content is 0.0005% or less, In and Mg are less than 0.02%, and Be, B, Zr, Y, Ag, Si, Ca and rare earths are added thereto (refer to Patent Document 9), a bonding wire for use in a semiconductor element wherein the coefficient of extension during rupture is 3% to 15% (refer to Patent Document 10), a metal wire for wire bonding wherein a gold plating layer is provided on the copper wire (refer to Patent Document 11), a copper thin wire superior in ultrasonic weldability wherein the copper purity is 99.999% or higher, and the tensile strength is less than 23 kg/mm² (refer to Patent Document 12), a bonding wire containing additive elements in an amount of 10ppm or less (refer to Patent Document 13), a bonding wire for use in a semiconductor integrated circuit element wherein the copper purity of the core is 99.99% to 99.999%, and the coating layer is 99.999% or higher (refer to Patent Document 14), a copper alloy ultrathin wire for use in a semiconductor device wherein the copper purity is 99.9999% or higher, the content of Fe and Ag is 0.1 % to 3.0%, and containing Mg in an amount of 0.5 to 400ppm (refer to Patent Document 15), a copper bonding wire wherein the copper purity is 99.9999% or higher, and containing rare earths or Zr in an amount of 0,0002% to 0.002% (refer to Patent Document 16), and a copper bonding wire that does not damage the electrode tip using a porous metal (refer to Patent Document 17), among others.

Nevertheless, all of these conventional technologies relate to a purity level of 5N to 6N. With that said, it should be known that it is not technically easy to industrially manufacture the foregoing high purity copper having a purity level of 5N to 6N. These technologies conform to the objective of conventional bonding wires.

In recent years, there are demands of copper bonding subject to thinning. Nevertheless, even with the foregoing high purity copper having a purity level of 5N to 6N, there is a problem in that the copper itself has a higher hardness in comparison to gold, and will rupture during the wire drawing process. In order to overcome this problem, the copper must possess a certain level of softness (low hardness). In addition, a high purity copper bonding wire having a purity level of 5N to 6N also had the problem of generating cracks in the silicon under the Al pad during adhesion.

Accordingly, practically speaking, the conventional technologies had problems in not being able to obtain a copper bonding wire that supersedes the performance of Au.
[Non-Patent Document 1] "Practical Application Technology of Copper Wire Bonding" (No. 42, 1989) pages 77 to 80
[Non-Patent Document 2] "Development of Copper Bonding Wire" Electronics Special Feature (No.10, 1991-1) pages 53 to 56
[Patent Document 1] Japanese Patent Laid-Open Publication No. S61-251062
[Patent Document 2] Japanese Patent Laid-Open Publication No. S61-255045
[Patent Document 3] Japanese Patent Laid-Open Publication No. S62-104061
[Patent Document 4] Japanese Patent Laid-Open Publication No. S62-20858
[Patent Document 5] Japanese Patent Laid-Open Publication No. S62-22469
[Patent Document 6] Japanese Patent Laid-Open Publication No. S62-89348
[Patent Document 7] Japanese Patent Laid-Open Publication No. S62-127436
[Patent Document 8] Japanese Patent Laid-Open Publication No. S62-216238
[Patent Document 9] Japanese Patent Laid-Open Publication No. S62-127438
[Patent Document 10] Japanese Patent Laid-Open Publication No. S63-3424
[Patent Document 11] Japanese Patent Laid-Open Publication No. S63-56924
[Patent Document 12] Japanese Patent Laid-Open Publication No. S63-72858
[Patent Document 13] Japanese Patent Laid-Open Publication No. S63-3424
[Patent Document 14] Japanese Patent Laid-Open Publication No. S63-236338
[Patent Document 15] Japanese Patent Laid-Open Publication No. H3-291340
[Patent Document 16] Japanese Patent Laid-Open Publication No. H4-247630
[Patent Document 17] Japanese Patent Laid-Open Publication No. 2003-174057

### DISCLOSURE OF THE INVENTION

An object of the present invention is to obtain a copper material that is compatible with the thinning (wire drawing) of the above. The conventional high purity copper having a purity level of 5N to 6N, which in itself is extremely high purity copper, was able to achieve a certain degree of softness by eliminating impurities as much as possible.

Nevertheless, although it cannot necessarily be said that the further purification of copper will lead to the reduction of hardness that will be compatible with thinning or the like, the present invention attempted to achieve higher purification of the high purity copper having a purity level of 5N to 6N. In other words, the present invention aims to develop technology for efficiently manufacturing ultrahigh purity copper having a purity of 8N (99.999999wt%) or higher, and provide extremely soft ultrahigh purity copper obtained thereby which in particular enables thinning. The present invention also aims to provide a bonding wire for use in a semiconductor element capable of preventing the generation of cracks in the silicon during bonding, inhibiting the heat generation caused by the low resistivity of wires, and preventing oxidization during heat treatment.

In order to achieve the foregoing objects, the present invention, based on the premise of realizing high purification through electrolytic refining, provides ultrahigh purity copper having a hardness of 40Hv or less, and a purity of 8N or higher (provided that this excludes the gas components of O, C, N, H, S and P). If the hardness is 40Hv or less, it is possible to prevent the generation of cracks in the silicon during bonding and enable thinning. The ultrahigh purity copper of this invention is able to achieve this object.

It is desirable that the respective elements of O, S and P as gas components are 1wtppm or less. These gas components (impurities) create a compound with Cu, and become deposited as a heterophase in the Cu. Although such heterophase deposits are extremely trivial in the ultrahigh purity copper, rupture will occur during the thinning process with such heterophase deposits as the origin. In addition, since the Cu will harden, cracks will easily occur in the silicon during bonding. Accordingly, it is necessary to reduce the foregoing gas components as much as possible.

Moreover, with the ultrahigh purity copper of the present invention, it is possible to achieve a recrystallization temperature of 200°C or less. Thus, annealing can be performed at low temperatures during the manufacture process such as the wire drawing process, and it is thereby possible to lower the hardness even further.

As a result of the foregoing configuration, thinning is enabled, and it is possible to obtain ultrahigh purity copper that is soft and suitable as a bonding wire.

Upon manufacturing the ultrahigh purity copper of the present invention, electrolytic solution comprised of copper nitrate solution added with hydrochloric acid is used, and electrolysis is performed with two-step electrolysis. The electrolytic solution is circulated. The liquid temperature of the circulated solution is temporarily set to be 10°C or less, and impurities such as AgCl are deposited and eliminated with a filter so as to obtain a further purified electrolytic solution. The electrolysis temperature is set to be 10 to 70°C. Like this, by performing electrolysis more than twice, it is possible to obtain high purity copper having a purity level of 8N or higher. If the electrolysis temperature is less than 10°C, impurities such as oxygen will increase and the electrodeposited Cu will become brittle. If the electrolysis temperature exceeds 70°C, the evaporation of the electrolytic solution will become a significant loss. Accordingly, it is desirable to set the electrolysis temperature to 10 to 70°C.

### [Effect of the Invention]

As described above, the present invention yields a significant effect of being able to efficiently manufacture ultrahigh purity copper having a purity level of 8N (99.999999wt%) or higher. It is thereby possible to reduce the hardness and obtain a copper material that is compatible with thinning (wire drawing).

In particular, thinning of a bonding wire for a semiconductor element is enabled. In addition, the present invention yields a superior effect of being able to prevent the generation of cracks in the silicon during bonding, inhibit the heat generation caused by the low resistance of the wires, and prevent the oxidization during heat treatment.

Since the improvement of corrosion resistance (oxidation resistance) will not require the heating atmosphere to be a strict Ar + H₂ atmosphere, an additional effect is yielded in that the labor efficiency is also favorable.

### BEST MODE FOR CARRYING OUT THE INVENTION

A bulk copper raw material having a purity level of 4N was used as the anode, a copper plate was used as the cathode, and an electrolytic solution comprised of copper nitrate solution was used to perform electrolysis based on two-step electrolysis. Since only a purity level of 5 to 7N can be obtained in the first step, electrolysis must be performed with two or more steps. The copper raw material (4N) primarily contains large amounts of O, P and S.

In the primary electrolysis, the bath temperature was set to 15°C or less, a nitric acid series electrolytic solution was used, and hydrochloric acid was added to the electrolytic solution in an amount of 0.1 to 100ml/L. This is in order to eliminate Ag as AgCl.

Then, electrolysis was performed at pH of 0 to 4, and current density of 0.1 to 10A/dm². The electrolytic solution was circulated, the electrolytic solution of the circuit was cooled with a cooler to a temperature of 10°C or less to deposit AgCl, and a filter was used to eliminate such AgCl and the like. It is thereby possible to obtain high purity copper having a purity level of 5N to 6N,

Subsequently, this copper having a purity level of 5N to 6N was used to perform electrolysis once again under the same electrolytic conditions as those described above. The electrolytic solution was similarly circulated, the electrolytic solution of the circuit was cooled with a cooler to a temperature of 10°C or less to deposit AgCl, and a filter was used to eliminate such AgCl and the like.

According to the foregoing process, it was possible to obtain electrodeposited copper (deposited on the cathode) having a purity level of 8N or higher. In other words, it was possible to realize a purity level of 8N (99.999999wt%) or higher excluding gas components, and to make all metallic component as impurities to be 0.01wtppm or less.

In addition, the electrodeposited copper obtained by the foregoing electrolysis may also be subject to vacuum melting such as by electron beam melting. As a result of performing such vacuum melting, it is possible to effectively eliminate alkali metals such as Na and K and other volatile impurities, as well as gas components such as Cl. As a result of performing degasification with reducible gas as necessary, it is possible to eliminate and reduce the gas components.

The ultrahigh purity copper having a purity level of 8N or higher manufactured as described above satisfies the condition of having a hardness of 40Hv or less, and it is also possible to achieve a recrystallization temperature of 200°C or less.

### [Examples]

Examples of the present invention are now explained. These Examples merely illustrate a preferred example, and the present invention shall in no way be limited thereby.

### (Example 1)

A bulk copper raw material having a purity level of 4N was used as the anode, and a copper plate was used as the cathode to perform electrolysis. The content of raw material impurities is shown in Table 1. As shown in Table 1, the copper raw material (4N) primarily contained large amounts of O, P and S. Table 1 also shows the hardness and recrystallization temperature at this impurity level. The hardness at a purity level of 4N was 45Hv, and the recrystallization temperature was 450°C. The diameter of the wire rod capable of being subject to thinning was 200*µ*m. The wires at this level were hard and generated cracks in the silicon during bonding (adhesion).

A nitric acid series electrolytic solution having a bath temperature of 30°C was used, and 1ml/L of hydrochloric acid was additionally added thereto. Electrolysis was performed at a pH of 1.3, and a current density of 1A/dm². The electrolytic solution was circulated, the electrolytic solution of the circuit was temporarily cooled with a cooler to a temperature of 2°C, and a filter was used to eliminate the deposited AgCl and the like. Thereby, as shown in Table 1, it was possible to obtain high purity copper having a purity level of 6N. Table 1 shows the hardness and recrystallization temperature of copper having a purity level of 6N. Hardness of the 6N copper was 42Hv, and the recrystallization temperature was reduced to 230°C. The diameter of the wire rod capable of being subject to thinning was 40*µ*m. Some cracks were generated in the silicon during bonding (adhesion), but this was not as significant as the 4N Cu.

Subsequently, this copper having a purity level of 6N was used to perform electrolysis once again under the same electrolytic conditions as those described above. The electrolytic solution was similarly circulated, the electrolytic solution of the circuit was temporarily cooled with a cooler to a temperature of 0°C, and a filter was used to eliminate the deposited AgCl and the like. Thereby, as shown in Table 1, it was possible to obtain ultrahigh purity copper having a purity level of 9N.

Table 1 shows the hardness and recrystallization temperature of copper having a purity level of 9N. The hardness was 38Hv, and the recrystallization temperature decreased to 150°C. The diameter of the wire rod capable of being subject to thinning was 2*µ*m, and improved significantly. No cracks were generated in the silicon during bonding (adhesion).

Example 1 achieved all conditions of the present invention; namely, the hardness being 40Hv or less and the recrystallization temperature being 200°C or less.

**[Table 1]**

| | | | | | | (O P, S: wtppm) | |
|---|---|---|---|---|---|---|---|
| Purity | Hardness Hv | O | P | S | Recrystallization Temperature (°C) | Thinning Diameter | Existence of Si Cracks |
| 4N | 45 | 10 | 0.2 | 8.6 | 450 | 200*µ*m | Many |
| 6N | 42 | <1 | 0.01 | 0.02 | 230 | 40*µ*m | Few |
| 9N | 38 | <1 | <0.005 | <0.005 | 150 | 2*µ*m | None |

### (Example 2)

A bulk copper raw material having a purity level of 4N level was used as the anode, and a copper plate was used as the cathode to perform electrolysis. The content of raw material impurities is shown in Table 2. As shown in Table 2, the copper raw material (4N) primarily contained large amounts of O, P and S. Table 2 also shows the hardness and recrystallization temperature at this impurity level. The hardness at a purity level of 4N was 47Hv, and the recrystallization temperature was 450°C. The diameter of the wire rod capable of being subject to thinning was 200*µ*m.

A nitric acid series electrolytic solution having a bath temperature of 25°C was used, and 1 ml/L of hydrochloric acid was additionally added thereto. Electrolysis was performed at a pH of 2.0, and a current density of 1.5A/dm². The electrolytic solution was circulated, and, as with Example 1, the electrolytic solution of the circuit was temporarily cooled with a cooler to a temperature of 5°C, and a filter was used to eliminate the deposited AgCl and the like. Thereby, as shown in Table 2, it was possible to obtain high purity copper having a purity level of 5N5. Table 2 shows the hardness and recrystallization temperature of copper having a purity level of 5N5. Hardness of the 5N5 copper was 43Hv, and the recrystallization temperature was reduced to 280°C. The diameter of the wire rod capable of being subject to thinning was 50*µ*m.

Subsequently, this copper having a purity level of 5N5 was used to perform electrolysis once again under the same electrolytic conditions as those described above. The electrolysis was performed by setting the electrolytic solution to a temperature of 20°C. The electrolytic solution was similarly circulated, the electrolytic solution of the circuit was temporarily cooled with a cooler to a temperature of 3°C, and a filter was used to eliminate the deposited AgCl and the like. Thereby, as shown in Table 2, it was possible to obtain ultrahigh purity copper having a purity level of 8N.

Table 2 shows the hardness and recrystallization temperature of copper having a purity level of 8N. The hardness was 40Hv, and the recrystallization temperature decreased to 180°C. The diameter of the wire rod capable of being subject to thinning was 5*µ*m, and improved significantly.

Example 2 achieved all conditions of the present invention; namely, the hardness being 40Hv or less and the recrystallization temperature being 200°C or less.

**[Table 2]**

| | | | | | | (O, P, S: wtppm) | |
|---|---|---|---|---|---|---|---|
| Purity | Hardness Hv | O | P | S | Recrystallization Temperature (°C) | Thinning Diameter | Existence of Si Cracks |
| 4N | 47 | 30 | 1.0 | 12 | 480 | 200*µ*m | Many |
| 5N5 | 43 | <1 | 0.1 | 0.6 | 280 | 50*µ*m | Few |
| 8N | 40 | <1 | <0.01 | <0.01 | 180 | 5*µ*m | None |

### (Comparative Example 1)

A bulk copper raw material having a purity level of 4N was used as the anode, and a copper plate was used as the cathode to perform electrolysis. The content of raw material impurities is shown in Table 3. As shown in Table 3, the copper raw material (4N) primarily contained large amounts of O, P and S. Table 3 also shows the hardness and recrystallization temperature at this impurity level. The hardness at a purity level of 4N was 45Hv, and the recrystallization temperature was 450°C. The diameter of the wire rod capable of being subject to thinning was 200*µ*m.

A nitric acid series electrolytic solution having a bath temperature of 20°C was used, and 1ml/L of hydrochloric acid was additionally added thereto. Electrolysis was performed at a pH of 1.3, and a current density of 1A/dm². The electrolytic solution was circulated but not cooled, and used as the electrolytic solution as is. Thereby, as shown in Table 3, it was possible to obtain high purity copper having a purity level of 4N5. Table 3 shows the hardness and recrystallization temperature of copper having a purity level of 4N5. Hardness of the 4N5 copper was 44Hv. The recrystallization temperature was 430°C, and did not decrease significantly. The diameter of the wire rod capable of being subject to thinning was 150*µ*m, but not very effective.

Subsequently, this copper having a purity level of 4N5 was used to perform electrolysis once again under the same electrolytic conditions as those described above. Thereby, as shown in Table 3, it was possible to obtain high purity copper having a purity level of 5N.

Table 3 shows the hardness and recrystallization temperature of copper having a purity level of 5N. The hardness was high at 43Hv, and the recrystallization temperature decreased to 420°C. The diameter of the wire rod capable of being subject to thinning was 120µm, and insufficient.

As described above, Comparative Example 1 did not satisfy all conditions of the present invention; namely, the hardness being 40Hv or less and the recrystallization temperature being 200°C or less, and did not achieve sufficient softness for realizing the thinning of a bonding wire. In addition, numerous cracks were generated in the silicon under the Al pad during heat bonding.

**[Table 3]**

| | | | | | | (O, P, S: wtppm) | |
|---|---|---|---|---|---|---|---|
| Purity | Hardness Hv | O | P | S | Recrystallization Temperature (°C) | Thinning Diameter | Existence of Si Cracks |
| 4N | 45 | 10 | 0.2 | 8.6 | 450 | 200*µ*m | Many |
| 4N5 | 44 | 10 | 0.1 | 2.0 | 430 | 150*µ*m | Yes |
| 5N | 43 | 10 | 0.1 | 1.0 | 420 | 120*µ*m | Yes |

### (Comparative Example 2)

A bulk copper raw material having a purity level of 4N level was used as the anode, and a copper plate was used as the cathode to perform electrolysis, The content of raw material impurities is shown in Table 4. As shown in Table 4, the copper raw material (4N) primarily contained large amounts of O, P and S. Table 4 also shows the hardness and recrystallization temperature at this impurity level. The hardness at a purity level of 4N was 45Hv, and the recrystallization temperature was 450°C. The diameter of the wire rod capable of being subject to thinning was 200*µ*m.

A nitric acid series electrolytic solution having a bath temperature of 35°C was used, and 1ml/L of hydrochloric acid was additionally added thereto. Electrolysis was performed at a pH of 1.3, and a current density of 1A/dm². The electrolytic solution was only circulated. Thereby, as shown in Table 4, it was possible to obtain high purity copper having a purity level of 4N5. Table 4 shows the hardness and recrystallization temperature of copper having a purity level of 4N5. Hardness of the 4N5 copper was 44Hv. The recrystallization temperature decreased to 430°C. The diameter of the wire rod capable of being subject to thinning was 150*µ*m.

Subsequently, this copper having a purity level of 4N5 was used to perform electrolysis once again under the same electrolytic conditions as those described above. In addition, the electrolytic solution of the circuit was temporarily cooled with a cooler to a temperature of 15°C, and a filter was used to eliminate the deposited AgCl and the like. Thereby, as shown in Table 4, it was possible to obtain high purity copper having a purity level of 6N.

Table 4 shows the hardness and recrystallization temperature of copper having a purity level of 6N. The hardness was high at 42Hv, and the recrystallization temperature decreased to 230°C. The diameter of the wire rod capable of being subject to thinning was 40*µ*m, and insufficient.

As described above, Comparative Example 2 did not satisfy the conditions of the present invention; namely, the hardness being 40Hv or less and the recrystallization temperature being 200°C or less, and did not achieve sufficient softness for realizing the thinning of a bonding wire. In addition, numerous cracks were generated in the silicon under the Al pad during heat bonding.

**[Table 4]**

| | | | | | | (O, P, S: wtppm) | |
|---|---|---|---|---|---|---|---|
| Purity | Hardness Hv | O | P | S | Recrystallization Temperature (°C) | Thinning Diameter | Existence of Si Cracks |
| 4N | 45 | 10 | 0.2 | 8.6 | 450 | 200*µ*m | Many |
| 4N5 | 44 | 10 | 0.1 | 2.0 | 430 | 150*µ*m | Yes |
| 6N | 42 | <1 | 0.01 | 0.02 | 230 | 40*µ*m | Yes |

### INDUSTRIAL APPLICABILITY

As described above, the present invention yields a significant effect of being able to efficiently manufacture ultrahigh purity copper having a purity of 8N (99.999999wt%) or higher, It is thereby possible to obtain a copper material with reduced hardness and compatible with thinning (wire drawing). In particular, thinning of a bonding wire for a semiconductor element is enabled. In addition, the present invention yields a superior effect of being able to prevent the generation of cracks in the silicon during bonding, inhibit the heat generation caused by the low resistance of the wires, and prevent the oxidization during heat treatment.

Accordingly, the present invention is suitable for a copper bonding wire for a semiconductor element that requires thinning.

## Claims

1. A method of manufacturing ultrahigh purity copper based on two-step electrolysis using an electrolytic solution comprised of copper nitrate solution, including the procedures of adding hydrochloric acid in an amount of 0.1 to 100 ml/L to an electrolytic solution comprised of copper nitrate solution; circulating the electrolytic solution; and performing two-step electrolysis while eliminating impurities with a filter upon temporarily setting the circulating electrolytic solution to a temperature of 10 deg. C or less.

## Patentansprüche

1. Verfahren zur Herstellung von ultrahochreinem Kupfer auf Basis einer Zwei-Schritt-Elektrolyse unter Verwendung einer elektrolytischen Lösung bestehend aus Kupfernitratlösung, beinhaltend die Vorgänge des Hinzufügens von Salzsäure in einer Menge von 0,1 bis 100 ml/l zu einer elektrolytischen Lösung bestehend aus Kupfernitratlösung; Zirkulieren der elektrolytischen Lösung; und Durchführung einer Zwei-Schritt-Elektrolyse bei gleichzeitiger Beseitigung von Verunreinigungen mit einem Filter nach vorübergehendem Einstellen der zirkulierenden elektrolytischen Lösung auf eine Temperatur von 10 Grad C oder weniger.

## Revendications

1. Procédé de fabrication d'un cuivre de ultra-haute pureté basé sur une électrolyse en deux étapes utilisant une solution électrolytique constituée d'une solution de nitrate de cuivre, comprenant les procédures consistant à ajouter de l'acide chlorhydrique à hauteur de 0,1 à 100 ml/l à une solution électrolytique constituée d'une solution de nitrate de cuivre ; mettre en circulation la solution électrolytique ; et réaliser une électrolyse en deux étapes tout en éliminant les impuretés à l'aide d'un filtre après réglage temporaire de la solution électrolytique en circulation à une température inférieure ou égale à 10 °C.
